# EUROPÄISCHE PATENTSCHRIFT

(11) **EP 0 293 497 B1**
(45) Veröffentlichungstag und Bekanntmachung des Hinweises auf die Patenterteilung: **10.03.1993**
(21) Anmeldenummer: 87107669.1
(22) Anmeldetag: 26.05.1987
(51) Int. Cl.: G01R 31/28, G01R 1/067

(54) **Kontaktsonden-Anordnung mit Feinpositionier-Vorrichtung**
Arrangement of probes with a device for accurate positioning
Arrangement de sondes avec leur dispositif de positionnement

(43) Veröffentlichungstag der Anmeldung: 07.12.1988
(73) Patentinhaber: IBM DEUTSCHLAND GMBH, D-70569 Stuttgart (DE); International Business Machines Corporation, Armonk, N.Y. 10504 (US)
(72) Erfinder: Stoehr, Roland R., D-7031 Nufringen (DE)
(74) Vertreter: Mönig, Anton, Dipl.-Ing.

(56) Entgegenhaltungen:
- EP-A- 0 165 331
- DE-A- 2 724 479
- US-A- 3 787 768

## Beschreibung

Die Erfindung bezieht sich auf eine Kontaktsonden-Anordnung mit Feinpositionier-Einrichtung gemäß dem Oberbegriff des Anspruchs 1.

Aus der US-A-3 787 768 ist eine Kontaktsonden-Anordnung zum elektrischen Verbinden einer Prüfeinrichtung mit den kreisförmigen Anschlußflächen eines Prüflings, mit einer motorgetriebenen Feinpositionier-Einrichtung mit eine Bewegungsübertragungseinheit, die eine Bewegung der Kontaktsonde in zwei zueinander senkrechten Richtungen gestattet, wobei für jede Richtung ein Elektromotor vorgesehen ist, die über räumlich dazwischen angeordnete Antriebswellen auf die Bewegungs-übertragungseinheit wirken. Diese Anordnung ist geeignet für die automatische Inspektion von gedruckten Leiterplatten.

Die DE-A-27 24 479 offenbart eine Kontaktsonden-Anordnung mit Feinpositionier-Vorrichtung. Diese Vorrichtung besitzt eine exzentrische Welle, die bei ihrer Rotation einen Schlitten hin- und herbewegt, um ein Feinpositionieren der Prüfkontakte auszuführen.

In der EP-A-283545 ist eine Kontaktsonden-Anordnung zur elektrischen Verbindung einer Prüfeinrichtung mit den kreisförmigen Anschlußflächen eines Prüflings beschrieben. Diese Anordnung gestattet es aufgrund der Verwendung eines Stapels aufeinandergeschichteter Langlochplatten, die als Kontaktsondenführungen dienen, Kontaktsonden verringerten Durchmessers zu verwenden und trotzdem den für zuverlässige Prüfergebnisse erforderlichen geringen Kontaktwiderstand zwischen Kontaktsonde und Anschlußfläche des Prüflings zu gewährleisten.

Zur Verringerung des Zeitaufwandes bei der Prüfung von Prüflingen, die eine regelmäßige Anordnung sich wiederholender Muster von Anschlußfläshen aufweisen, ist es bekannt, mehrere Kontaktsonden-Anordnungen zu einem Prüfkopf, wie er beispielsweise aus der EP-A-165331 bekannt ist, zusammenzufassen und sämtliche Kontaktsonden-Anordnungen gleichzeitig mit den Mustern der Anschlußflächen in Kontakt zu bringen. Dies ist jedoch nur dann möglich, wenn beim Herstellungsprozeß des Prüflings keine größeren Abweichungen der Abmessungen seiner Anschlußflächen von den Soll-Maßen auftreten. Ist das jedoch der Fall, so liefert ein gleichzeitiges Kontaktieren aller Muster der Anschlußflächen durch einen Prüfkopf, der mehrere Kontaktsonden-Anordnungen enthält, keine zuverlässigen Prüfergebnisse mehr, da eine Kontaktsonde infolge der durch den Herstellungsprozeß bedingten Verzerrungen des Prüflings entweder die ihr zugeordnete Anschlußfläche nicht mehr trifft oder eine Anschlußfläche kontaktiert, die nicht ihr, sondern einer benachbarten Kontaktsonde zugeordnet ist.

Hier will die Erfindung Abhilfe schaffen. Die Erfindung, wie sie in den Ansprüchen gekennzeichnet ist, löst die Aufgabe, eine Kontaktsonden-Anordnung zu schaffen, die auch dann zuverlässige Prüfergebnisse liefert, wenn mehrere Kontaktsonden-Anordnungen zu einem Prüfkopf zusammengefaßt sind und die Abmessungen der Anschlußflächen des Prüflings aufgrund des Herstellungsprozesses größere Abweichungen von den Soll-Werten aufweisen.

Im folgenden wird die Erfindung in Verbindung mit den Zeichnungen näher erläutert, von denen zeigen:
- FIG. 1: eine vereinfachte perspektivische Darstellung, teilweise als Schnitt, eines ersten Ausführungsbeispiels einer gemäß der Erfindung mit einer Feinpositionier-Vorrichtung versehenen Kontaktsonden-Anordnung, bei der aus Gründen der Übersichtlichkeit Lager und der Befestigung dienende Bauteile nicht dargestellt sind;
- FIG. 2: eine Zeichnung zur Erläuterung der Feinpositionierung in der X-Richtung;
- FIG. 3: eine Zeichnung zur Erläuterung der Feinpositionierung in der X-Richtung senkrechten Y-Richtung;
- FIG. 4: eine vereinfachte perspektivische Darstellung eines zweiten Ausführungsbeispiels einer erfindungsgemäßen Feinpositionier-Vorrichtung für eine Kontaktsonden-Anordnung;
- FIG. 5: eine perspektivische Schnittansicht eines Prüfkopfes, der aus Kontaktsonden-Anordnungen aufgebaut ist, die mit einer Feinpositionier-Einrichtung entsprechend dem ersten Ausführungsbeispiel versehen sind.

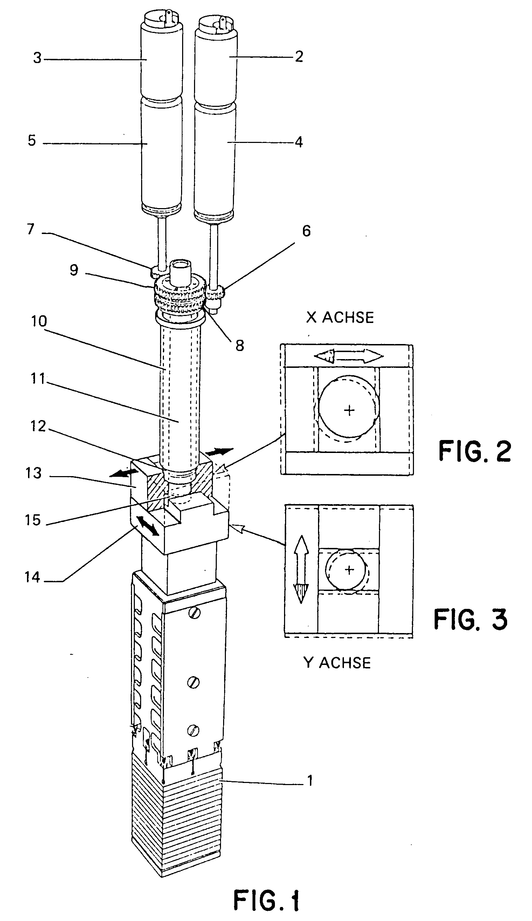

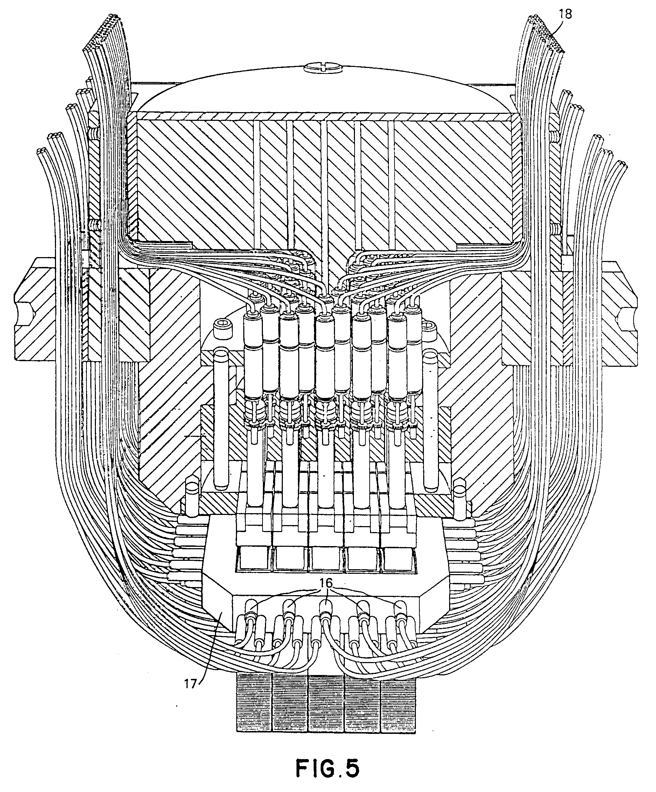

FIG. 1 zeigt ein erstes Beispiel für eine Kontaktsonden-Anordnung mit einer Kontaktsonde 1 die mit einer erfindungsgemäßen Einrichtung zur Feinpositionierung in zwei zueinander senkrechten Richtungen, die als X- und als Y-Richtung bezeichnet werden. Für die Bewegung in jeder Richtung ist ein Motor 2 bzw. 3 vorgesehen. Der Motor 2 bzw. 3 ist mit einem Getriebe 4 bzw. 5 verbunden, dessen Abtriebswelle ein Antriebszahnrad 6 bzw. 7 trägt, das mit einem Zahnrad 8 bzw. 9 zusammenarbeitet. Das Zahnrad 8 bzw. 9 sitzt auf einer Hohlwelle 10 bzw. 11. Die Hohlwelle 10 bewirkt die Feinpositionierung der Kontaktsonde 1 in der X-Richtung. Dazu ist ihr unteres Ende 12 exzentrisch ausgebildet und in einem Mitnehmerteil 13 gelagert, der bei der Drehung des exzentrischen Endes 12 der Hohlwelle 10 die mit ihm über ein weiteres Mitnehmerteil 14 verbundene Kontaktsonde 1 in der X-Richtung nach links oder rechts bewegt, wie das in der FIG. 2 dargestellt ist, die eine Draufsicht auf das Mitnehmerteil 13 und die es bewegende Welle 10 mit ihrem exzentrisch ausgebildeten unteren Ende 12 zeigt. Für die Bewegung der Kontaktsonde 1 in der zur X-Richtung senkrechten Y-Richtung ist innerhalb der senkrecht gelagerten Hohlwelle 10 eine weitere Hohlwelle 11 vorgesehen. Sie trägt an ihrem oberen Ende ebenfalls ein Zahnrad 9, das wie das der anderen Hohlwelle 10 durch ein Ritzel 7 angetrieben wird. Die Hohlwelle 11 ist an ihrem unteren Ende ebenfalls exzentrisch ausgebildet. Dadurch wird ein unter dem ersten Mitnehmerteil 13 angeordnetes, fest mit ihm und der Kontaktsonde 1 verbundenes zweites Mitnehmerteil 14 über den Exzenter 15 in der Y-Richtung vor- oder zurückbewegt, wie das in der FIG. 3 angedeutet ist, in der die schraffierte Pfeilspitze die Bewegungsrichtung nach vorn andeutet. Bei der Verwendung eines Exzenters als Antriebselement, das eine Drehbewegung in eine hin- und hergehende Bewegung umwandelt, besteht keine lineare Beziehung zwischen dem Drehwinkel und der Verschiebung in einer Richtung. Für das Feinpositionieren der Kontaktsonde ist es aber unerlässlich, eine Information über den zurückgelegten Weg zu erhalten. Deshalb ist, wie das aus dem perspektivischen Schnittbild der FIG. 5 zu ersehen ist, für jede Kontaktsonde 1 ein Sensor 16 vorgesehen, der eine Information über den bei der Feinpositionierung einer Kontaktsonde 1 zurückgelegten Weg liefert. Als Sensoren 16 können bekannte induktive Wegaufnehmer verwendet werden. Sie sind in den Bohrungen eines unbeweglichen Rahmens 17 angeordnet, der fest mit dem Gehäuse des Prüfkopfes, der eine Reihe von Kontaktsonde 1 enthält, verbunden. Jeder Sensor 16 gibt bei Veränderung des Abstandes zwischen seiner Spitze und der ihm zugeordneten Kontaktsonde 1 ein entsprechendes Signal ab, das über eines der in FIG. 5 dargestellten Kabel 18 einer Steuerschaltung für die Antriebsmotoren der Kontaktsonde 1 zugeführt wird.

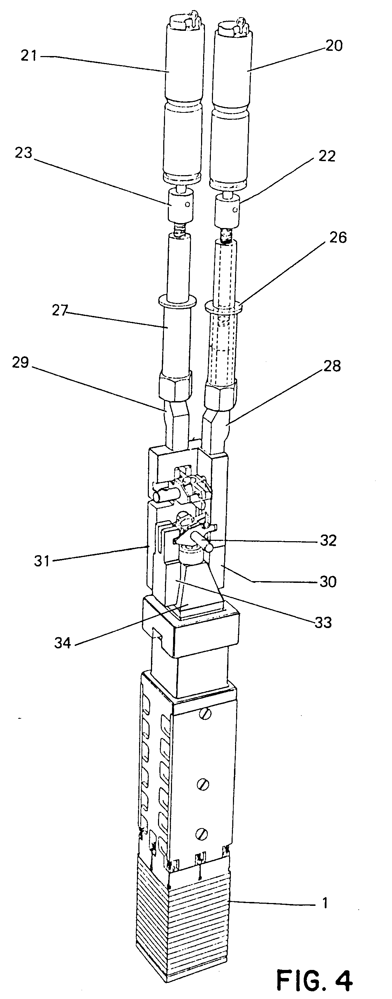

FIG. 4 zeigt ein zweites Ausführungsbeispiel für eine feinpositionierbare Kontaktsonde 1. Wie bei dem ersten Ausführungsbeispiel sind auch bei diesem zwei Antriebsmotoren, 20 und 21, vorgesehen, von denen der Motor 20 die Feinpositionierung der Kontaktsonde in der X-Richtung und der Motor 21 die in der Y-Richtung bewirkt. Jede Motorachse ist über eine Kupplung 22 bzw. 23 und ein Differentialgewinde 26 bzw. 27 mit einem gabelförmig ausgebildeten Teil 28 bzw. 29 verbunden, das an seinem unteren Ende einen Keil 30 bzw. 31 trägt. Mit der Kontaktsonde 1 ist ein vierseitiger Pyramidenstumpf 34 fest verbunden. Auf zwei gegenüberliegenden Seitenflächen liegen jeweils die beiden einer Bewegungsrichtung zugeordneten Keile 30 bzw. 33 auf. Die beiden Keile 30 und 33 dienen der Bewegung der Kontaktsonde in X-Richtung. Von den beiden Keilen für die Bewegung in der Y-Richtung ist in FIG. 4 aus Gründen der bes. seren Übersichtlichkeit nur der hintere Keil 31 dargestellt.

Soll die Kontaktsonde 1 zum Beispiel etwas nach rechts bewegt werden, wird das gabelförmige Teil 30 nach oben bewegt. Dabei wird der an seinem unteren Ende angeordnete Keil 30 etwas von der Seitenfläche des Pyramidenstumpfes 34 abgehoben, während gleichzeitig der Keil 33 über den linken Arm einer Wippe 32 auf der Seitenfläche des Pyramidenstumpfes nach unten bewegt wird. Dadurch wird die Kontaktsonde etwas nach rechts bewegt. Der rechte Arm der Wippe 32 greift in eine Ausnehmung des gabelförmig ausgebildeten Teils 28 ein. Für eine Bewegung nach links wird das gabelförmige Teil 28 etwas nach unten bewegt, dadurch wird über die Wippe 32 der Keil 33 von der Pyramidenfläche etwas abgehoben. Dadurch kann bei der Abwärtsbewegung des Keiles 30 die Kontaktsonde 1 sich etwas nach links bewegen. Für die Bewegung in der dazu senkrechten Richtung gilt entsprechendes.

Im Gegensatz zu dem Ausführungsbeispiel nach FIG. 1 sind für das Ausführungsbeispiel nach FIG. 4 zur Erfassung des zurückgelegten Weges keine Sensoren erforderlich, da in diesem Fall der zurückgelegte Weg mit Hilfe einer in den Motoren angeordneten, nicht gesondert dargestellten Codiervorrichtung aus den Motorumdrehungen bestimmt werden kann.

Gemäß einer besonderen Ausgestaltung des Prüfkopfes enthält dieser eine ungerade Anzahl von matrixartig angeordneten Kontaktsonden, bei dem die im Schnittpunkt der Matrix-Diagonale angeordnete Kontaktsonde keine Feinpositionier-Einrichtung aufweist.

## Patentansprüche

1. Kontaktsonden-Anordnung zum elektrischen Verbinden einer Prüfeinrichtung mit den kreisförmigen Anschlußflächen eines Prüflings,
mit einer motorgetriebenen Feinpositionier-Einrichtung mit einer Bewegungsübertragungseinheit (12-15; 30-34), wobei die Bewegungsübertragungseinheit (12-15; 30-34) eine Bewegung einer Kontaktsonde (1) der Kontaktsonden-Anordnung in zwei zueinander senkrechte Richtungen überträgt, wobei für jede Richtung ein Elektromotor (2, 3; 20, 21) vorgesehen ist, die über Antriebswellen (10, 11; 27, 28) auf die Bewegungs-übertragungseinheit (12-15; 30-34) wirken,
dadurch gekennzeichnet,
daß die Elektromotoren (2, 3; 20, 21) derart über der Bewegungsübertragungseinheit (12-15; 30-34) angeordnet sind, daß die Längsachse der Kontaktsonde (1) senkrecht zu der durch die beiden Bewegungsrichtungen bestimmten Ebene und parallel zu den Motorachsen und zu den Antriebswellenachsen verläuft.

2. Kontaktsonden-Anordnung nach Anspruch 1, dadurch gekennzeichnet,
daß das Feinpositionieren in jeder der beiden zueinander senkrechten Richtungen über eine Hohlwelle (10, 11) erfolgt, die an ihrem unteren Ende exzentrisch ausgebildet ist derart, daß sie bei ihrer Rotation einen Mitnehmerschlitten hin- und herbewegt, der mit der Kontaktsonde (1) fest verbunden ist, und dadurch seine Bewegung auf sie überträgt.

3. Kontaktsonden-Anordnung nach Anspruch 2, dadurch gekennzeichnet,
daß die Hohlwelle (11) für die zweite Bewegungsrichtung innerhalb der Hohlwelle (10) für die erste Bewegungsrichtung verläuft.

4. Kontaktsonden-Anordnung nach den Ansprüchen 1 bis 3, dadurch gekennzeichnet,
daß die infolge der Drehung der Hohlwellen (10, 11) erreichte Position der Kontaktsonde (1) über einen als induktiven Wegaufnehmer arbeitenden Sensor (16) ermittelt wird.

5. Kontaktsonden-Anordnung nach Anspruch 1, dadurch gekennzeichnet,
daß das Feinpositionieren in jeder der beiden zueinander senkrechten Richtungen durch je zwei Keile (30, 33) erfolgt, die auf den beiden gegenüberliegenden Seitenflächen eines vierseitigen, fest mit der Kontaktsonde verbundenen Pyramidenstumpfes (34) aufliegen und von denen jeweils einer beim Absenken nach unten die Verschiebung der Kontaktsonde (1) nach rechts oder links bzw. nach vorn oder hinten bewirkt.

6. Kontaktsonden-Anordnung nach Anspruch 5, dadurch gekennzeichnet,
daß die beiden einer Bewegungsrichtung zugeordneten Keile (30, 33) über eine Wippe (32) miteinander verbunden sind, deren einer Arm in die Ausnehmung eines gabelförmigen Teils (28) eingreift, an dessen unterem Ende der eine Keil (30) sich befindet, und deren zweiter Arm mit dem zweiten Keil (33) verbunden ist.

7. Verwendung mehrerer matrixartig angeordneter Kontaktsonden-Anordnungen nach Anspruch 1 in einem Prüfkopf.

8. Verwendung einer ungeraden Anzahl von matrixartig angeordneten Kontaktsonden-Anordnungen nach Anspruch 2 in einem Prüfkopf, bei dem die im Schnittpunkt der Matrix-Diagonale angeordnete Kontaktsonden-Anordnung keine Feinpositionier-Einrichtung aufweist.

## Claims

1. Contact probe assembly for electrically connecting a test unit to the circularly shaped connector pads of a device to be tested,
comprising a motor-driven fine positioning means with movement transmission means (12-15); 30-34), said movement transmission means (12-15; 30-34) transmitting a movement of a contact probe (1) of the contact probe assembly in two directions perpendicular to each other, one electromotor (2, 3; 20, 21), acting through drive shafts (10, 11; 27, 28) on the movement transmission means (12-15; 30-34), being provided for each direction
characterized in that
the electromotors (2, 3; 20, 21) are arranged above the movement transmission means (12-15; 30-34) such that the longitudinal axis of the contact probe (1) extends perpendicularly to the plane defined by the two directions of movement and parallel to the motor axes and the drive shaft axes.

2. Contact probe assembly according to claim 1, characterized in that
fine positioning in each of the two directions perpendicular to each other is effected by a hollow shaft (10, 11) having its lower end eccentrically shaped such that upon rotation of said shaft, a follower slide, permanently connected to the contact probe (1), is reciprocally moved, transmitting its movement thereto.

3. Contact probe assembly according to claim 2, characterized in that the hollow shaft (11) for the second direction of movement extends inside the hollow shaft (10).

4. Contact probe assembly according to claims 1 to 3, characterized in that the position reached by the contact probe (1) in response to the rotation of the hollow shafts (10, 11) is determined by a sensor (16) operating as an inductive displacement transducer.

5. Contact probe assembly according to claim 1, characterized in that fine positioning in either of the two perpendicular directions is effected by wedges (30, 33) resting on the two opposite side faces of a quadrangular pyramid frustrum (34), permanently connected to the contact probe, one wedge, upon being lowered, shifting the contact probe to the right or left and forwards and backwards, respectively.

6. Contact probe assembly according to claim 5, characterized in that the two wedges (30, 33) associated with one direction of movement each are interconnected by a seesaw (32), one arm of which engages the recess of a fork-shaped element (28) having a wedge (30) positioned at its lower end, and the other arm of which is connected to the second wedge (33).

7. Use of several contact probe assemblies, arranged in matrix fashion, according to claim 1 in a test head.

8. Use of an odd number of contact probe assemblies, arranged in matrix fashion, according to claim 2 in a test head, wherein the contact probe assembly positioned at the intersection of the matrix diagonal does not comprise a fine positioning means.

## Revendications

1. Arrangement de sondes de contact pour la liaison électrique d'un dispositif testeur avec les faces de connexion circulaires d'une pièce à tester,
avec un dispositif motorisé de positionnement fin comprenant une unité de transmission de mouvement (12-15; 30-34), l'unité de transmission de mouvement (12-15; 30-34) transmettant un mouvement d'une sonde de contact (1) de l'arrangement de sondes de contact dans deux directions mutuellement perpendiculaires, et un moteur électrique (2, 3; 20, 21) étant prévu pour chaque direction, ces moteurs agissant sur l'unité de transmission de mouvement (12-15; 30-34) par l'intermédiaire d'arbres de transmission (10, 11; 27, 28),
**caractérisé** en ce que les moteurs électriques (2, 3; 20, 21) sont disposés au-dessus de l'unité de transmission de mouvement (12-15; 30-34) de telle sorte que l'axe longitudinal de la sonde de contact (1) s'étend perpendiculairement au plan déterminé par les deux directions de déplacement et parallèlement aux axes des moteurs et aux axes des arbres de transmission.

2. Arrangement de sondes de contact selon la revendication 1, **caractérisé** en ce que le positionnement fin dans chacune des deux directions mutuellement perpendiculaires s'effectue par l'intermédiaire d'un arbre creux (10, 11) qui, à son extrémité inférieure, est configuré excentriquement de telle sorte que, lors de sa rotation, il déplace en va et vient un coulisseau entraîneur qui est rigidement assemblé à la sonde de contact (1) et transmet ainsi son déplacement à cette dernière.

3. Arrangement de sondes de contact selon la revendication 2, **caractérisé** en ce que l'arbre creux (11) pour la seconde direction de déplacement s'étend à l'intérieur de l'arbre creux (10) pour la première direction de déplacement.

4. Arrangement de sondes de contact selon l'une des revendications 1 à 3, **caractérisé** en ce que la position qui est atteinte par la sonde de contact (1) suite à la rotation des arbres creux (10, 11), est déterminée au moyen d'un capteur (16) travaillant comme capteur de déplacement inductif.

5. Arrangement de sondes de contact selon la revendication 1, **caractérisé** en ce que le positionnement fin dans chacune des deux directions mutuellement perpendiculaires s'effectue au moyen de deux clavettes respectives (30, 33), qui s'appliquent sur les deux faces latérales opposées d'une pyramide tronquée (34) à quatre côtés, rigidement assemblée à la sonde de contact et qui produisent respectivement, lors de leur abaissement vers le bas, le déplacement de la sonde de contact (1) vers la droite ou la gauche, ou vers l'avant ou l'arrière.

6. Arrangement de sondes de contact selon la revendication 5, **caractérisé** en ce que les deux clavettes (30, 33) associées à une direction de déplacement sont mutuellement reliées par une bascule (32), dont un bras s'engage dans l'évidement d'une pièce fourchue (28) à l'extrémité inférieure de laquelle se trouve une clavette (30), et dont l'autre bras est relié à la seconde clavette (33).

7. Utilisation, dans une tête testeuse, de plusieurs arrangements de sondes de contact selon la revendication 1, disposés à la manière d'une matrice.

8. Utilisation d'un nombre impair d'arrangements de sondes de contact selon la revendication 1 disposés à la manière d'une matrice, dans une tête testeuse dans laquelle l'arrangement de sondes de contact disposé au point d'intersection des diagonales de la matrice ne présente pas de dispositif de positionnement fin.
